# EUROPEAN PATENT APPLICATION

(11) **EP 4 521 897 A1**
(43) Date of publication of application: **12.03.2025**
(21) Application number: 24195244.9
(22) Date of filing: 19.08.2024
(51) Int. Cl.: H10K 59/122, H10K 59/80

(54) **DISPLAY PANEL**

(30) Priority: 05.09.2023 KR 20230117444
(71) Applicant: Samsung Display Co., Ltd., Gyeonggi-Do (KR)
(72) Inventor: KWON, Junghyun, Yongin-si (KR); YOON, Ju-Won, Yongin-si (KR); KANG, Shin Tack, Yongin-si (KR); LEE, Jaebeen, Yongin-si (KR)
(74) Representative: Marks & Clerk LLP

(57) **Abstract**

A display panel includes a circuit board (100) and an element layer (200) disposed on the circuit board (100) and including a pixel defining layer (PDL) having a plurality of openings (OP-R, OP-G, OP-B), and a spacer (SPC) disposed on the pixel defining layer (PDL). The plurality of openings include a first opening (OP-R), a second opening (OP-G), and a third opening (OP-G) that are adjacent to the spacer (SPC). The spacer (SPC) includes a central portion (CP) disposed between the first, second, and third openings and a first extension (P1), a second extension (P2), and a third extension (P3) that protrude from the central portion (CP) in three directions, respectively. End portions of the first, second, and third extensions (P1-P3) are disposed in a region defined by virtual lines (AR) connecting a first center of the first opening (CP-R), a second center of the second opening (CP-G), and a third center of the third opening (CP-B).

## Description

### BACKGROUND

### 1. Technical Field

Embodiments described herein relate to a display panel with improved manufacturing yield and reliability and an electronic device including the display panel.

### 2. Description of the Related Art

A display panel may include pixels. Each of the pixels may include an emissive layer disposed between electrodes opposite each other. The emissive layer may be formed through various methods, and one of them may be a deposition method using a mask. The display panel may include a spacer that supports a mask.

### SUMMARY

Embodiments provide a display panel capable of improving manufacturing yield and reliability and an electronic device including the display panel.

However, embodiments are not limited to those set forth herein. The above and other embodiments will become more apparent to one of ordinary skill in the art to which the disclosure pertains by referencing the detailed description of the disclosure given below.

According to an embodiment, a display panel includes a circuit board including a pixel circuit and an element layer that is disposed on the circuit board and that includes a plurality of light emitting elements, a pixel defining layer having a plurality of openings overlapping the plurality of light emitting elements, respectively, and a spacer disposed on the pixel defining layer. The plurality of openings include a first opening, a second opening, and a third opening, and each of the first, second, and third openings are adjacent to the spacer. The spacer includes a central portion disposed between the first, second, and third openings, a first extension that extends from the central portion to be disposed between the first opening and the second opening, a second extension that extends from the central portion to be disposed between the second opening and the third opening, and a third extension that extends from the central portion to be disposed between the third opening and the first opening. End portions of the first, second, and third extensions are disposed within a region defined by virtual lines connecting a first center of the first opening, a second center of the second opening, and a third center of the third opening.

The spacer may include a plurality of layers, and at least one layer among the plurality of layers may include a conductive material.

The spacer may include a first layer having a first width and a second layer that is disposed on the first layer and that has a second width smaller than the first width of the first layer.

The spacer may include a plurality of spacers, and the plurality of spacers may include a first spacer and a second spacer closest to the first spacer. At least two light emitting elements among the plurality of light emitting elements may be disposed between the first spacer and the second spacer.

Each of the first opening, the second opening, and the third opening may have a polygonal shape.

The first opening may include a first side that faces the first extension, the second opening may include a second side that faces the first extension, and the end portion of the first extension may be aligned with or spaced apart from a virtual line connecting a center of the first side and a center of the second side.

The pixel defining layer may include an inorganic material, and the spacer may include an inorganic material.

The end portions of the first, second, and third extensions may have a round shape, an angled shape, or a pointed shape.

A first angle of a side surface of the pixel defining layer that defines the first opening with respect to a bottom surface of the pixel defining layer may be about 40 degrees or less.

A second angle of a side surface of the spacer with respect to a bottom surface of the spacer may be greater than or equal to the first angle.

The spacer may be thicker than the pixel defining layer.

A plurality of valleys recessed from an upper surface of the pixel defining layer may be defined in the pixel defining layer, and the plurality of valleys may surround at least portions of the first, second, and third openings, respectively.

The spacer may be disposed between the plurality of valleys.

The display panel may further include a plurality of protruding patterns that are disposed on the pixel defining layer and that surround at least portions of the first, second, and third openings, respectively.

The spacer may have a thickness greater than thicknesses of the plurality of protruding patterns.

According to an embodiment, a display panel may include a circuit board including a pixel circuit and an element layer that is disposed on the circuit board and that includes a light emitting element including a first electrode, an intermediate layer, and a second electrode, a pixel defining layer having an opening overlapping a portion of the first electrode, and a spacer disposed on the pixel defining layer. The spacer may include a central portion, and a first extension, a second extension, and a third extension that protrude from the central portion in three directions, respectively, and the pixel defining layer and the spacer may include an inorganic material.

A first angle of a side surface of the pixel defining layer that defines the opening with respect to a bottom surface of the pixel defining layer may be less than or equal to a second angle of a side surface of the spacer with respect to a bottom surface of the spacer.

A first angle of a side surface of the pixel defining layer that defines the opening with respect to a bottom surface of the pixel defining layer may be about 40 degrees or less.

The spacer may be thicker than the pixel defining layer.

The spacer may include a plurality of layers, and at least one layer among the plurality of layers may include a conductive material.

The spacer may include a first layer having a first width and a second layer that is disposed on the first layer and that has a second width smaller than the first width.

The opening may have a polygonal shape and may include a first side that faces the first extension, and an end portion of the first extension may be aligned with or spaced apart from a normal line that extends from a center of the first side.

The spacer may include a plurality of spacers, and the plurality of spacers may include a first spacer and a second spacer closest to the first spacer. The light emitting element may include a plurality of light emitting elements. At least two light emitting elements among the plurality of light emitting elements may be disposed between the first spacer and the second spacer.

According to an embodiment, a display panel may include a circuit board including a pixel circuit and an element layer that is disposed on the circuit board and that includes a light emitting element including a first electrode, an intermediate layer, and a second electrode, a pixel defining layer having an opening overlapping a portion of the first electrode, and a spacer disposed on the pixel defining layer. The spacer may include a central portion, and a first extension, a second extension, and a third extension that protrude from the central portion in three directions, respectively. A first angle of a side surface of the pixel defining layer that defines the opening with respect to a bottom surface of the pixel defining layer is about 40 degrees or less.

A second angle of a side surface of the spacer with respect to a bottom surface of the spacer may be greater than or equal to the first angle.

The pixel defining layer and the spacer may each include an inorganic material.

The spacer may include a plurality of layers, and at least one layer among the plurality of layers may include a conductive material.

The spacer may include a first layer having a first width and a second layer that is disposed on the first layer and that has a second width smaller than the first width.

According to an embodiment, an electronic device may include a display panel that displays an image and a housing accommodating the display panel. The display panel may include a circuit board including a pixel circuit and an element layer that is disposed on the circuit board and that includes a plurality of light emitting elements, a pixel defining layer having a plurality of openings overlapping the plurality of light emitting elements, respectively, and a spacer disposed on the pixel defining layer. The plurality of openings may include a first opening, a second opening, and a third opening, and each of the first, second, and third openings is adjacent to the spacer. The spacer may include a central portion disposed between the first, second, and third openings, a first extension that extends from the central portion to be disposed between the first opening and the second opening, a second extension that extends from the central portion to be disposed between the second opening and the third opening, and a third extension that extends from the central portion to be disposed between the third opening and the first opening. End portions of the first, second, and third extensions may be disposed in a region defined by virtual lines connecting a first center of the first opening, a second center of the second opening, and a third center of the third opening.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings.
FIG. 1 is a schematic perspective view of an electronic device according to an embodiment.
FIG. 2 is a schematic view illustrating the use of the electronic device according to an embodiment.
FIG. 3 is an exploded schematic perspective view illustrating a portion of the electronic device according to an embodiment.
FIG. 4 is an enlarged schematic plan view illustrating a partial region of a display panel according to an embodiment.
FIG. 5A is a schematic sectional view of a display panel according to an embodiment.
FIG. 5B is a schematic sectional view of a display panel according to an embodiment.
FIG. 5C is a schematic sectional view of a display panel according to an embodiment.
FIG. 6A is a schematic sectional view of a display panel according to an embodiment.
FIG. 6B is a schematic sectional view of a display panel according to an embodiment.
FIG. 7A is an enlarged schematic plan view illustrating a partial region of a display panel according to an embodiment.
FIG. 7B is an enlarged schematic plan view illustrating a partial region of a display panel according to an embodiment.
FIG. 7C is an enlarged schematic plan view illustrating a partial region of a display panel according to an embodiment.
FIG. 8A is a schematic sectional view of a partial region of a display panel according to an embodiment.
FIG. 8B is a schematic sectional view of a partial region of a display panel according to an embodiment.
FIG. 8C is a schematic sectional view of a partial region of a display panel according to an embodiment.
FIG. 8D is a schematic sectional view of a partial region of a display panel according to an embodiment.
FIG. 8E is a schematic sectional view of a partial region of a display panel according to an embodiment.
FIG. 9 is a schematic sectional view of a partial region of a display panel according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described with reference to the accompanying drawings.

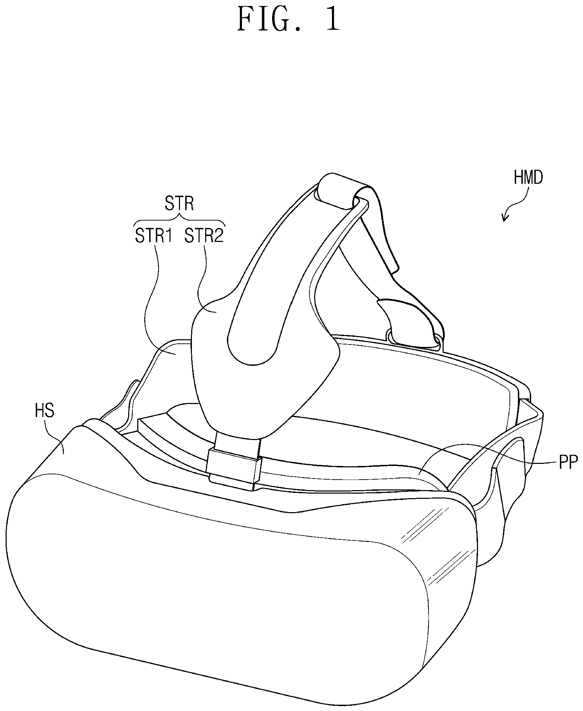

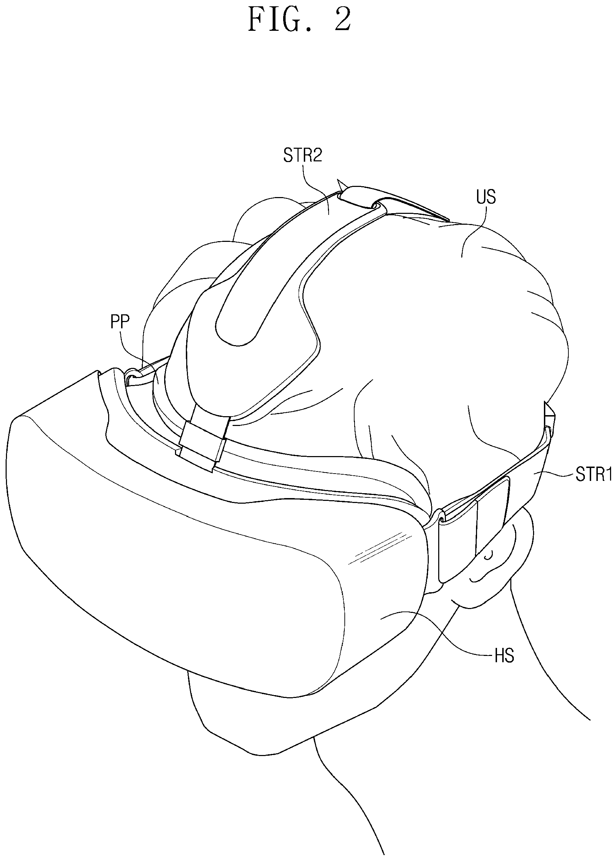

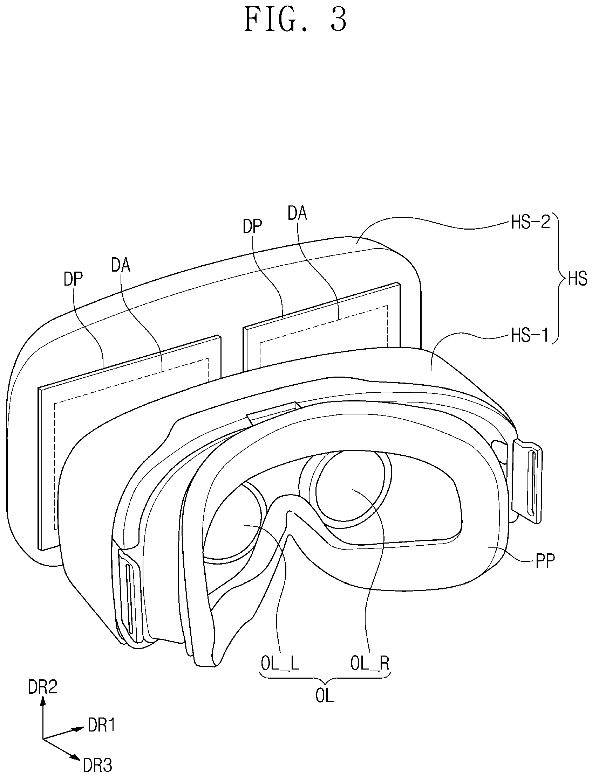

FIG. 1 is a perspective schematic view of an electronic device HMD according to an embodiment. FIG. 2 is a schematic view illustrating the use of the electronic device HMD according to an embodiment. FIG. 3 is an exploded schematic perspective view illustrating a portion of the electronic device HMD according to an embodiment.

Referring to FIGS. 1, 2, and 3, the electronic device HMD may be a device activated according to an electrical signal. For example, the electronic device HMD may be a mobile phone, a foldable mobile phone, a notebook computer, a television, a tablet computer, a car navigation unit, a game machine, or a wearable device, but embodiments are not limited thereto. The wearable device, which is worn on a part of a user's body, may include a head mounted display (HMD) device that implements extended Reality (XR). Although FIG. 1 illustrates an example that the electronic device HMD is a head mounted display device, embodiments are not limited thereto.

The electronic device HMD may be a display device worn on the head of a user US. The electronic device HMD may provide an image and may block an actual peripheral view of the user US. The user US, wearing the electronic device HMD, may be more readily immersed in virtual reality.

The electronic device HMD may include a body HS, a strap STR, a cushion PP, and display panels DP. For example, the electronic device HMD may include various types of sensors, a camera, and the like.

The body HS may be worn on the head of the user US. The display panels DP that display images and an acceleration sensor may be accommodated inside the body HS. The acceleration sensor may sense a movement of the user US and may transfer certain signals to the display panels DP. Accordingly, the display panels DP may provide images corresponding to a change in the gaze of the user US. Thus, the user US may experience virtual reality similar to actual reality.

Components having various functions in addition to the above-described components may be accommodated inside the body HS. The body HS may be referred to as a housing or case. For example, an operation unit for adjusting volume, screen brightness, or the like may be additionally disposed on the outside of the body HS. The operation unit may be provided as a physical button, or may be provided in the form of a touch sensor. Furthermore, a proximity sensor for determining whether the user US has the electronic device HMD on may be accommodated inside the body HS. For example, an external display panel may be additionally disposed on the body HS.

The body HS may be divided into a body part HS-1 and a cover part HS-2. Although FIG. 3 illustrates an example that the body part HS-1 and the cover part HS-2 are separated from each other, embodiments are not limited thereto. For example, the body part HS-1 and the cover part HS-2 may be integral with each other and may not be separated from each other.

The display panels DP may be disposed between the body part HS-1 and the cover part HS-2. The display panels DP may provide images through display regions DA, respectively. Although FIG. 3 illustrates an example that a left-eye image and a right-eye image are provided by the display panels DP separated from each other, embodiments are not limited thereto. For example, the left-eye image and the right-eye image may be displayed through a single display panel. The display panels DP may be driven by separate drivers. However, without being limited thereto, the display panels DP may be driven by a single driver.

The display panels DP may generate images corresponding to input image data. The display panels DP may be organic light emitting display panels, inorganic light emitting display panels, organic-inorganic light emitting display panels, quantum-dot display panels, micro- light emitting organic diode (LED) display panels, nano-LED display panels, or liquid crystal display panels. In the embodiment, it will be described that the display panels DP are organic light emitting display panels. However, embodiments are not limited thereto.

The strap STR may be coupled with the body HS to enable the body HS to be readily worn on the head of the user US. The strap STR may include a main strap STR1 and an upper strap STR2.

The main strap STR1 may be worn along the circumference of the head of the user US. The main strap STR1 may fix the body HS to the head of the user US to bring the body HS into close contact with the head of the user US. The upper strap STR2 may connect the body HS and the main strap STR1 along the upper portion of the head of the user US. The upper strap STR2 may prevent the body HS from slipping down. For example, the upper strap STR2 may distribute the load of the body HS to further improve the wearing comfort of the user US.

Although FIG. 1 illustrates an example that the main strap STR1 and the upper strap STR2 are length adjustable, embodiments are not limited thereto. For example, in another example, the main strap STR1 and the upper strap STR2 may have elasticity, and the length-adjustable portions may be omitted.

As long as the strap STR is capable of fixing the body HS to the head of the user US, the strap STR may be modified into various forms other than that illustrated in FIGS. 1 and 2. For example, in another example, the upper strap STR2 may be omitted. Furthermore, in an embodiment, the strap STR may be modified into various forms, such as a helmet coupled with the body HS or eyeglass temples coupled with the body HS.

The cushion PP may be disposed between the body HS and the head of the user US. The cushion PP may be formed of a material whose shape is freely deformable. For example, the cushion PP may be formed of a polymer resin (e.g., polyurethane, polycarbonate, polypropylene, or polyethylene), or may be formed as a sponge made by foaming liquid rubber, a urethane-based material, or an acrylic-based material. However, embodiments are not limited thereto.

The cushion PP may bring the body HS into close contact with the head of the user US to improve the wearing comfort of the user US. The cushion PP may be detachable from the body HS. In another example, the cushion PP may be omitted.

An optical system OL may be disposed inside the body part HS-1 of the body HS. The optical system OL may enlarge images provided from the display panels DP. Each of the display panels DP may display an image in a third direction DR3 through the display region DA parallel to a first direction DR1 and a second direction DR2 intersecting the first direction DR1. The optical system OL may be spaced apart from the display panels DP in the third direction DR3. The optical system OL may be disposed between the display panels DP and the eyes of the user US. The optical system OL may include a right-eye optical system OL_R and a left-eye optical system OL_L. The left-eye optical system OL_L may enlarge and provide an image to the left pupil of the user US, and the right-eye optical system OL_R may enlarge and provide an image to the right pupil of the user US.

The left-eye optical system OL_L and the right-eye optical system OL_R may be spaced apart from each other in the first direction DR1. The distance between the right-eye optical system OL_R and the left-eye optical system OL_L may be adjusted to correspond to the distance between the two eyes of the user US. For example, the distance between the optical system OL and the display panels DP may be adjusted according to the visual acuity (or eyesight) of the user US.

The optical system OL may be a convex aspheric lens. For example, the optical system OL may be a pancake lens, but embodiments are not limited thereto. In the embodiment, it has been described that each of the left-eye optical system OL_L and the right-eye optical system OL_R is implemented with a single lens. However, embodiments are not limited thereto. For example, each of the left-eye optical system OL_L and the right-eye optical system OL_R may include a plurality of lenses.

In FIGS. 1 to 3, it has been described that the display panels DP are applied to the electronic device HMD, for example, a head mounted display device. However, embodiments are not limited thereto. For example, the display panels DP may also be applied to a bar-type electronic device, a foldable electronic device, a rollable electronic device, or a slidable electronic device.

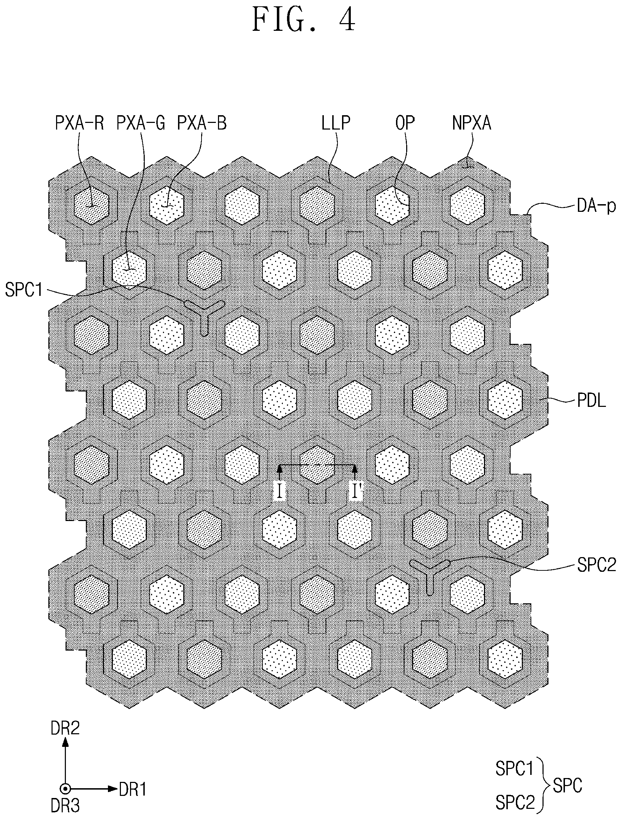

FIG. 4 is an enlarged schematic plan view illustrating a partial region DA-p of the display panel DP (refer to FIG. 3) according to an embodiment.

The partial region DA-p illustrated in FIG. 4 (hereinafter, referred to as the partial region) may be a portion of the display region DA (refer to FIG. 3). Emissive regions PXA-R, PXA-G, and PXA-B and spacers SPC included in the partial region DA-p may be repeatedly arranged in the first direction DR1 and the second direction DR2.

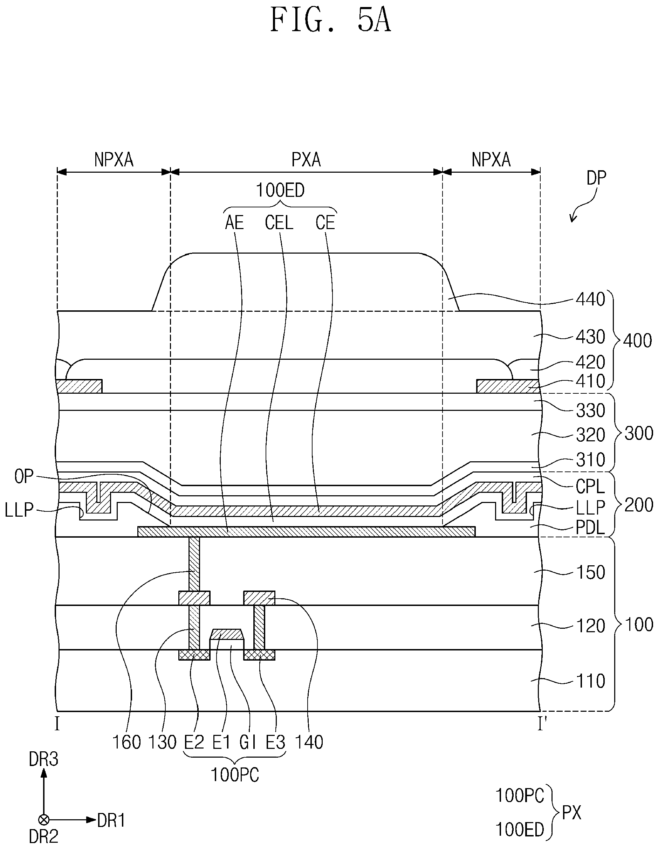

The display region DA of the display panel DP may include the emissive regions PXA-R, PXA-G, and PXA-B and a non-emissive region NPXA surrounding the emissive regions PXA-R, PXA-G, and PXA-B. The emissive regions PXA-R, PXA-G, and PXA-B may be regions divided from one another by a pixel defining layer PDL (refer to FIG. 5A) that will be described below. The non-emissive region NPXA may be a region between the adjacent emissive regions PXA-R, PXA-G, and PXA-B and may be a region corresponding to the pixel defining layer PDL. The emissive regions PXA-R, PXA-G, and PXA-B may be divided from one another to correspond to openings OP defined in the pixel defining layer PDL.

The emissive regions PXA-R, PXA-G, and PXA-B may correspond to light emitting elements, respectively. For example, an emissive region (e.g., single emissive region) PXA (refer to FIG. 5A) may be defined in a light emitting element (e.g., single light emitting element) 100ED (refer to FIG. 5A).

The emissive regions PXA-R, PXA-G, and PXA-B may include the first emissive region PXA-R, the second emissive region PXA-G, and the third emissive region PXA-B. In an embodiment, the first emissive region PXA-R, the second emissive region PXA-G, and the third emissive region PXA-B may display light having different wavelengths. The first emissive region PXA-R may display first light that is light having a red wavelength, the second emissive region PXA-G may display second light that is light having a green wavelength, and the third emissive region PXA-B may display third light that is light having a blue wavelength.

In an embodiment, the first emissive region PXA-R, the second emissive region PXA-G, and the third emissive region PXA-B may include emissive layers that output the same source light. For example, the source light may be white light or blue light. The source light may be converted into light having a different color by a wavelength conversion layer or a color filter layer included in the display panel DP. Accordingly, the first emissive region PXA-R, the second emissive region PXA-G, and the third emissive region PXA-B may display light having different wavelengths.

The first to third emissive regions PXA-R, PXA-G, and PXA-B may form a pixel (e.g., single pixel). For example, the pixel may include sub-pixels, and the first to third emissive regions PXA-R, PXA-G, and PXA-B may correspond to the sub-pixels in a one-to-one manner.

According to an embodiment, the display panel DP may be applied to an electronic device for implementing extended reality. For example, the display panel DP may be applied to an electronic device for implementing (or realizing) augmented reality or virtual reality. For example, to improve display quality, the display panel DP may be required to have a high resolution. For example, the first to third emissive regions PXA-R, PXA-G, and PXA-B may form a pixel (e.g., single pixel), and the pixel density of the display panel DP may be 3000 pixels per inch (PPI) or more.

In an embodiment, the first to third emissive regions PXA-R, PXA-G, and PXA-B may have substantially the same area. However, embodiments are not limited thereto. For example, the first to third emissive regions PXA-R, PXA-G, and PXA-B may have different areas according to the wavelengths of emitted light.

In an embodiment, the first to third emissive regions PXA-R, PXA-G, and PXA-B may have a polygonal shape (e.g., in plan view). For example, each of the first to third emissive regions PXA-R, PXA-G, and PXA-B may have a hexagonal shape, but embodiments are not limited thereto.

In an embodiment, control patterns LLP that surround the first to third emissive regions PXA-R, PXA-G, and PXA-B and overlap the non-emissive region NPXA may be defined or disposed in the display panel DP. The control patterns LLP may at least partially surround the first to third emissive regions PXA-R, PXA-G, and PXA-B, respectively. For example, a control pattern (e.g., single control pattern) LLP may surround an emissive region (e.g., single emissive region) (e.g., PXA-R). Although FIG. 4 illustrates an example that the control pattern LLP completely surrounds the emissive region PXA-R, embodiments are not limited thereto. For example, the control pattern LLP may surround only a portion of the emissive region PXA-R.

The control patterns LLP may prevent lateral leakage current from being generated between the adjacent emissive regions PXA-R, PXA-G, and PXA-B. In this specification, the "lateral leakage current" refers to a current flowing in another direction intersecting the third direction DR3 other than a current flowing in the third direction DR3, which is the stacking direction of a light emitting element, e.g., in the direction in which an image is displayed. The lateral leakage current may refer to a current flowing in a direction parallel to a plane defined by the first direction DR1 and the second direction DR2 in the plane.

According to an embodiment, the spacers SPC may be disposed between the emissive regions PXA-R, PXA-G, and PXA-B. The spacers SPC may include a first spacer SPC1 and a second spacer SPC2 closest to the first spacer SPC1. Among the emissive regions PXA-R, PXA-G, and PXA-B, two or more emissive regions may be disposed between the first spacer SPC1 and the second spacer SPC2. Furthermore, since the emissive regions are defined to correspond to the light emitting elements, respectively, two or more light emitting elements may be disposed between the first spacer SPC1 and the second spacer SPC2.

In the case that the spacers SPC are disposed in respective regions adjacent to the three emissive regions PXA-R, PXA-G, and PXA-B unlike in the embodiment, the number of spacers SPC may be increased to correspond to an increase in the resolution of the display panel DP. For example, the amount of an organic material accumulated on the upper surfaces of the spacers SPC may be increased, and the organic material may be transferred to a mask. The foreign matter transferred to the mask may make stabbed marks on the emissive regions in a process of aligning the mask and the display panel DP being processed, which causes dark spot defects.

According to an embodiment, the spacers SPC may be disposed only in some of the regions adjacent to the three emissive regions PXA-R, PXA-G, and PXA-B. Since the number of spacers SPC is decreased when compared to that in the above-described comparative example, the amount of the organic material accumulated on the upper surfaces of the spacers SPC may also be decreased. Accordingly, the possibility of the dark spot defects may also be reduced. Although FIG. 4 illustrates an example that forty-eight emissive regions PXA-R, PXA-G, and PXA-B and two spacers SPC are disposed in a partial region (or single partial region) DA-p, embodiments are not limited thereto.

According to an embodiment, forty-eight emissive regions PXA-R, PXA-G, and PXA-B and two spacers SPC having the same arrangement relationship as the partial region DA-p shown in FIG. 4 may be alternately and repeatedly arranged along the first direction DR1 and the second direction DR2.

In an embodiment, the arrangement density of the spacers SPC may be lower than the pixel density. For example, the three emissive regions PXA-R, PXA-G, and PXA-B in FIG. 4 may form a pixel (e.g., single pixel). For example, it may be understood that sixteen pixels are illustrated in FIG. 4. Accordingly, the arrangement density of the spacers SPC may be about 1/8 of the pixel density. However, embodiments are not limited thereto.

In an embodiment, the partial region DA-p illustrated in FIG. 4 may have a width of about 28.8 µm in the first direction DR1 and a width of about 28.8 µm in the second direction DR2. The emissive regions PXA-R, PXA-G, and PXA-B and the spacers SPC included in the partial region DA-p may be repeatedly arranged in the first direction DR1 and the second direction DR2. Accordingly, the distance between spacers SPC closest to each other in the first direction DR1 may be about 28.8 µm, and the distance between spacers SPC closest to each other in the second direction DR2 may be about 28.8 µm. The center of the second spacer SPC2 illustrated in FIG. 4 may be spaced apart from the center of the first spacer SPC1 by about 14.4 µm in the first direction DR1 and about 14.4 µm in the second direction DR2. Furthermore, the shortest distance between the center of the first spacer SPC1 and the center of the second spacer SPC2 may be about 20.3 µm. However, the distances and widths are not limited to the above-described numerical values.

FIG. 5A is a schematic sectional view of the display panel DP according to an embodiment. FIG. 5A is a schematic sectional view of the display panel DP taken along line I-I' of FIG. 4.

Referring to FIGS. 4 and 5A, the display panel DP may include a circuit board 100, an element layer 200, an encapsulation layer 300, and an optical layer 400.

The circuit board 100 may include a base substrate 110 and a pixel circuit 100PC on the base substrate 110. The base substrate 110 may be a silicon substrate, a germanium substrate, or a silicon-on-insulator (SOI) substrate. For example, the base substrate 110 may be a single-crystalline silicon substrate, but embodiments are not limited thereto.

The pixel circuit 100PC may include a transistor. The transistor may be a metal oxide semiconductor field effect transistor (MOSFET). The pixel circuit 100PC may include a gate electrode E1 over the base substrate 110, a gate dielectric pattern GI between the gate electrode E1 and the base substrate 110, and source/drain regions E2 and E3 on opposite sides of the gate electrode E1. The source/drain regions E2 and E3 may be impurity implantation regions formed on the opposite sides of the gate electrode E1 in the base substrate 110.

The gate electrode E1 may include at least one of a doped semiconductor material, conductive metal nitride (e.g., titanium nitride, tantalum nitride, or the like), and metal (e.g., aluminium, tungsten, or the like). The gate dielectric pattern GI may include silicon oxide. The source/drain regions E2 and E3 may have a conductivity type different from that of the base substrate 110. The source/drain regions E2 and E3 may include N-type impurities (e.g., phosphorus (P) or arsenic (As)) or P-type impurities (e.g., boron (B)).

The circuit board 100 may further include a lower interlayer insulating layer 120. The lower interlayer insulating layer 120 may be formed on the base substrate 110 and may cover the pixel circuit 100PC. The lower interlayer insulating layer 120 may include an oxide layer, a nitride layer, or an oxy nitride layer. Lower conductive contacts 130 may be formed in the lower interlayer insulating layer 120 and may be connected to the source/drain regions E2 and E3, respectively. The lower conductive contacts 130 may include a conductive material.

The circuit board 100 may further include wiring pattern layers 140. The wiring pattern layers 140 may be formed on the lower interlayer insulating layer 120. Each of the lower conductive contacts 130 may be connected to a corresponding one of the wiring pattern layers 140. The wiring pattern layers 140 may include, for example, metal. For example, additional wiring pattern layers may be formed between the lower interlayer insulating layer 120 and the wiring pattern layers 140. For example, each of the lower conductive contacts 130 may be electrically connected to the corresponding wiring pattern layer 140 through a corresponding one of the additional wiring pattern layers. The additional wiring pattern layers may include, for example, metal.

The circuit board 100 may further include an upper interlayer insulating layer 150. The upper interlayer insulating layer 150 may be formed on the lower interlayer insulating layer 120 and may cover the wiring pattern layers 140. The upper interlayer insulating layer 150 may include an oxide layer, a nitride layer, or an oxy nitride layer.

The element layer 200 may be disposed on the circuit board 100. The element layer 200 may include light emitting elements 100ED. In FIG. 5A, a light emitting element 100ED is representatively illustrated. An emissive region PXA may be defined to correspond to the light emitting element 100ED. The emissive region PXA may be defined by an opening OP defined in the pixel defining layer PDL. For example, the pixel circuit 100PC and the light emitting element 100ED may be connected (e.g., electrically connected) to each other and may form a pixel PX.

The light emitting element 100ED may include a first electrode AE, an intermediate layer CEL, and a second electrode CE. The first electrode AE may be referred to as a pixel electrode or an anode, and the second electrode CE may be referred to as a common electrode or a cathode. The intermediate layer CEL may include a functional layer commonly provided in the emissive regions PXA-R, PXA-G, and PXA-B and an emissive layer subjected to patterning to correspond to each of the emissive regions PXA-R, PXA-G, and PXA-B.

The first electrode AE may be disposed on the circuit board 100. The first electrode AE may be connected to a corresponding one of the wiring pattern layers 140 through an upper conductive contact 160 penetrating the upper interlayer insulating layer 150. The first electrode AE may be a transmissive electrode, a semi-transmissive electrode, or a reflective electrode. In an embodiment, the first electrode AE may include a reflective layer formed of silver, magnesium, aluminium, platinum, palladium, gold, nickel, neodymium, iridium, chromium, titanium, titanium nitride, or a compound thereof and a transparent or translucent electrode layer formed on the reflective layer. The transparent or translucent electrode layer may include at least one selected from the group consisting of indium tin oxide, indium zinc oxide, indium gallium zinc oxide, zinc oxide, or indium oxide and aluminium-doped zinc oxide. For example, the first electrode AE may include a multi-layer structure in which indium tin oxide, silver, and indium tin oxide are sequentially stacked one above another.

The pixel defining layer PDL may be disposed on the circuit board 100. The opening OP for exposing a portion of the first electrode AE may be defined in the pixel defining layer PDL. For example, the pixel defining layer PDL may cover the periphery of the first electrode AE. The emissive region PXA may be defined by the pixel defining layer PDL. The pixel defining layer PDL may have a single-layer structure or a multi-layer structure. The pixel defining layer PDL may include an inorganic material. For example, the pixel defining layer PDL may include at least one of silicon oxide, silicon nitride, and silicon oxy nitride.

In an embodiment, a control pattern LLP overlapping the non-emissive region NPXA may be defined in the pixel defining layer PDL. The control pattern LLP may have a shape recessed in the third direction DR3, which is the thickness direction, from the upper surface of the pixel defining layer PDL. Accordingly, the control pattern LLP may be referred to as a valley, a valley pattern, a groove, or a groove pattern. The depth of the control pattern LLP may be smaller than the thickness of the pixel defining layer PDL. Accordingly, a side surface and a bottom surface of the control pattern LLP may be defined by the pixel defining layer PDL.

The intermediate layer CEL may be disposed on the first electrode AE and the pixel defining layer PDL. The second electrode CE may be disposed on the intermediate layer CEL. In an embodiment, the thickness of the intermediate layer CEL may be decreased by the control pattern LLP. For example, some of the layers included in the intermediate layer CEL may be broken. For example, leakage of current to the portion where the control pattern LLP is formed may be prevented.

The element layer 200 may further include a capping layer CPL disposed on the second electrode CE. The capping layer CPL may function to improve light emission efficiency by the principle of constructive interference. The capping layer CPL may include, for example, a material having a refractive index of about 1.6 or more for light having a wavelength of about 589 nm. The capping layer CPL may be an organic capping layer including an organic material, an inorganic capping layer including an inorganic material, or a composite capping layer including an organic material and an inorganic material. For example, the capping layer CPL may include a carbocyclic compound, a heterocyclic compound, an amine group-containing compound, a porphine derivative, a phthalocyanine derivative, a naphthalocyanine derivative, an alkali metal complex, an alkaline earth metal complex, or a combination thereof. The carbocyclic compound, the heterocyclic compound, and the amine group-containing compound may be selectively substituted with a substituent including oxygen (O), nitrogen (N), sulfur (S), selenium (Se), silicon (Si), fluorine (F), chlorine (Cl), bromine (Br), iodine (I), or a combination thereof.

The encapsulation layer 300 may be disposed on the element layer 200. The encapsulation layer 300 may include a first inorganic encapsulation layer 310, an organic encapsulation layer 320, and a second inorganic encapsulation layer 330 that are sequentially stacked one above another. The first and second inorganic encapsulation layers 310 and 330 may protect the element layer 200 from moisture and oxygen, and the organic encapsulation layer 320 may protect the element layer 200 from foreign matter such as dust particles. In an embodiment, the encapsulation layer 300 may be formed as a single layer. For example, the encapsulation layer 300 may include only an inorganic encapsulation layer.

The optical layer 400 may be disposed on the encapsulation layer 300. The optical layer 400 may include a dividing layer 410, color filters 420, a cover layer 430, and a lens pattern layer 440.

The material of the dividing layer 410 is not limited as long as it is a material that absorbs light. The dividing layer 410 may be a black layer. In an embodiment, the dividing layer 410 may include a black coloring agent. The black coloring agent may include a black dye or a black pigment. The black coloring agent may include carbon black, metal such as chromium, or oxide thereof.

The color filter 420 may be disposed to correspond to an opening defined in the dividing layer 410. The color filter 420 may transmit light provided from the intermediate layer CEL overlapping the color filter 420. The color reproduction of light provided from the intermediate layer CEL may be improved by the color filter 420.

The cover layer 430 may cover the color filter 420. The cover layer 430 may include an organic material, but embodiments are not limited thereto. The lens pattern layer 440 may be arranged in a region overlapping the opening OP of the pixel defining layer PDL and may have a shape that convexly protrudes. However, the shape of the lens pattern layer 440 is not limited thereto. The cover layer 430 and the lens pattern layer 440 may include the same material and may have an integrated shape.

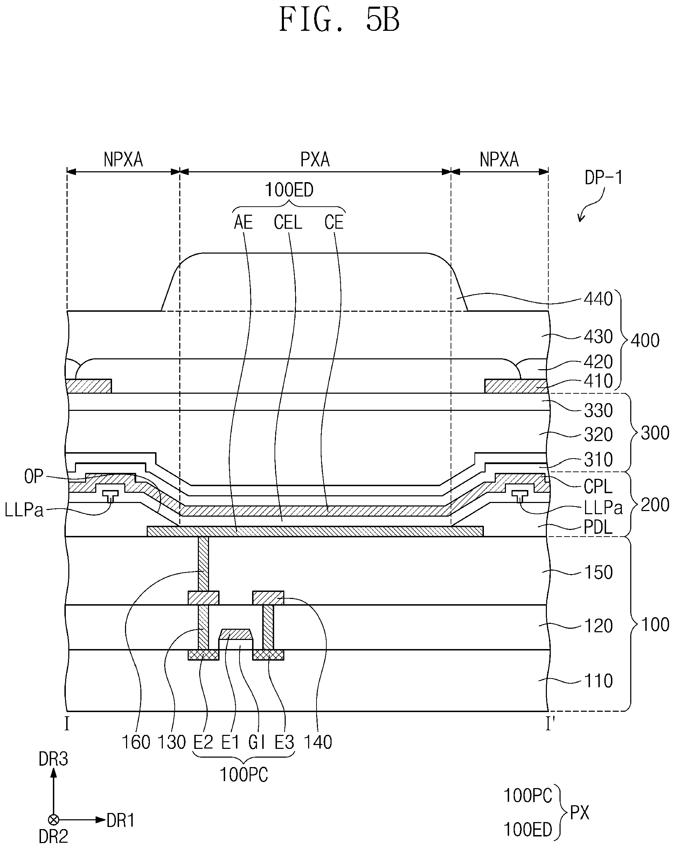

FIG. 5B is a schematic sectional view of a display panel DP-1 according to an embodiment. In describing FIG. 5B, components identical to the components described with reference to FIG. 5A will be assigned with identical reference numerals, and descriptions thereabout will be omitted for descriptive convenience.

Referring to FIGS. 4 and 5B, the display panel DP-1 may further include a control pattern LLPa. The control pattern LLPa of the display panel DP-1 differs from the control pattern LLP of FIG. 5A.

The control pattern LLPa may be disposed in the pixel defining layer PDL. The control pattern LLPa may have a shape protruding from the upper surface of the pixel defining layer PDL. Accordingly, the control pattern LLPa may be referred to as a protruding pattern LLPa.

The control pattern LLPa may include a lower portion and an upper portion having a greater width than the lower portion. The upper portion of the control pattern LLPa may be spaced apart from the pixel defining layer PDL with the lower portion therebetween. For example, a tip portion may be defined in the control pattern LLPa by the upper and lower portions having different widths.

The intermediate layer CEL may be disposed on the first electrode AE, the pixel defining layer PDL, and the control pattern LLPa. In an embodiment, the thickness of the intermediate layer CEL may be decreased by the control pattern LLPa. For example, some of the layers included in the intermediate layer CEL may be broken. For example, leakage of current to the portion where the control pattern LLPa is formed may be prevented.

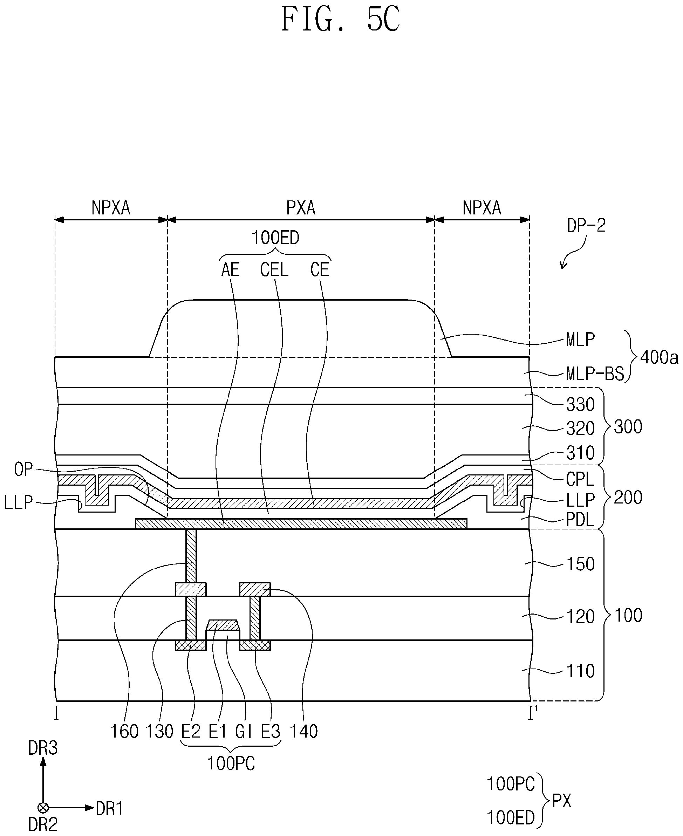

FIG. 5C is a schematic sectional view of a display panel DP-2 according to an embodiment. In describing FIG. 5C, components identical to the components described with reference to FIG. 5A will be assigned with identical reference numerals, and descriptions thereabout will be omitted for descriptive convenience.

Referring to FIGS. 4 and 5C, the display panel DP-2 may include the circuit board 100, the element layer 200, the encapsulation layer 300, and an optical layer 400a. The optical layer 400a differs from the optical layer 400 of FIG. 5A.

The optical layer 400a may include a base layer MLP-BS and a lens pattern layer MLP. The base layer MLP-BS and the lens pattern layer MLP may include the same material and may have an integrated shape. The base layer MLP-BS and the lens pattern layer MLP may include an organic material, but embodiments are not limited thereto. In another example, the base layer MI,P-BS may be omitted. For example, the lens pattern layer MLP may be directly disposed on the encapsulation layer 300.

In an embodiment, the first emissive region PXA-R, the second emissive region PXA-G, and the third emissive region PXA-B may display light having different wavelengths. Accordingly, the color filter 420 illustrated in FIG. 5A may be omitted. For example, the light efficiency of the display panel DP-2 may be further improved, and the display panel DP-2 may display an image having higher brightness.

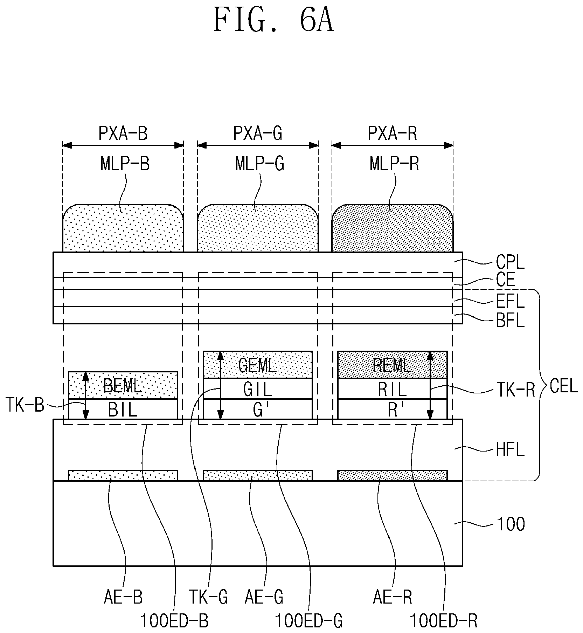

FIG. 6A is a schematic sectional view of the display panel DP (refer to FIG. 5A) according to an embodiment.

Referring to FIGS. 5A and 6A, a first light emitting element 100ED-R having a first emissive region PXA-R defined therein, a second light emitting element 100ED-G having a second emissive region PXA-G defined therein, and a third light emitting element 100ED-B having a third emissive region PXA-B defined therein are illustrated as an example.

A first electrode AE-R of the first light emitting element 100ED-R, a first electrode AE-G of the second light emitting element 100ED-G, and a first electrode AE-B of the third light emitting element 100ED-B may be disposed on the circuit board 100. The intermediate layer CEL that covers the first electrodes AE-R, AE-G, and AE-B may be disposed on the circuit board 100.

The intermediate layer CEL may include a first functional layer HFL, first auxiliary layers RIL and R', second auxiliary layers GIL and G', a third auxiliary layer BIL, a first emissive layer REML, a second emissive layer GEML, a third emissive layer BEML, a buffer layer BFL, and a second functional layer EFL. However, this is illustrative, and some of the components included in the intermediate layer CEL may be omitted. The intermediate layer CEL may further include other components.

The first functional layer HFL may include a hole transport layer (HTL), may include a hole injection layer (HIL), or may include both the hole transport layer and the hole injection layer. The first functional layer HFL may be disposed in the entire display region DA (refer to FIG. 3). Accordingly, the first functional layer HFL may overlap the opening OP of the pixel defining layer PDL and the control patterns LLP (refer to FIG. 4) of the pixel defining layer PDL.

The first auxiliary layers RIL and R', the second auxiliary layers GIL and G', and the third auxiliary layer BIL may be disposed on the first functional layer HFL. The first auxiliary layers RIL and R', the second auxiliary layers GIL and G', and the third auxiliary layer BIL may be layers that function to increase the light emission efficiency of a dopant and a host, but embodiments are not limited thereto. In an embodiment, some of the first auxiliary layers RIL and R', the second auxiliary layers GIL and G', and the third auxiliary layer BIL may be omitted, and other auxiliary layers may be additionally disposed.

The first emissive layer REML, the second emissive layer GEML, and the third emissive layer BEMI, may be disposed on the first auxiliary layers RIL and R', the second auxiliary layers GIL and G', and the third auxiliary layer BIL, respectively. The first emissive layer REML, the second emissive layer GEML, and the third emissive layer BEMI, may include organic materials, inorganic materials, or organic-inorganic materials that emit light of certain colors. The first auxiliary layers RIL and R', the second auxiliary layers GIL and G', and the third auxiliary layer BIL may be disposed in the first to third emissive regions PXA-R, PXA-G, and PXA-B, respectively. The first emissive layer REML, the second emissive layer GEML, and the third emissive layer BEMI, may be disposed in the first to third emissive regions PXA-R, PXA-G, and PXA-B, respectively.

In an embodiment, the first auxiliary layers RIL and R' and the first emissive layer REMI, may be formed using a first mask, for example, a fine metal mask. For example, the first mask may include a mask opening, and deposition materials may pass through the opening and may be deposited on a target substrate to form the first auxiliary layers RIL and R' and the first emissive layer REML. The second auxiliary layers GIL and G' and the second emissive layer GEMI, may be formed using a second mask, and the third auxiliary layer BIL and the third emissive layer BEMI, may be formed using a third mask. The second mask and the third mask may also be fine metal masks.

The spacer SPC (refer to FIG. 4) may function to support the masks in the case that the first emissive layer REML, the second emissive layer GEML, the third emissive layer BEML, the first auxiliary layers RIL and R', the second auxiliary layers GIL and G', and the third auxiliary layer BIL are formed using the masks.

The buffer layer BFL may be disposed over the first emissive layer REML, the second emissive layer GEML, and the third emissive layer BEML. For example, the buffer layer BFL may be disposed over the first functional layer HFL and may cover the first emissive layer REML, the second emissive layer GEML, the third emissive layer BEML, the first auxiliary layers RIL and R', the second auxiliary layers GIL and G', and the third auxiliary layer BIL. In another example, the buffer layer BFL may be omitted.

The second functional layer EFL may be disposed on the buffer layer BFL. The second functional layer EFL may include an electron transport layer (ETL), may include an electron injection layer (EIL), or may include both the electron transport layer and the electron injection layer. The second functional layer EFL may be disposed in the entire display region DA (refer to FIG. 3). Accordingly, the second functional layer EFL may overlap the opening OP of the pixel defining layer PDL and the control patterns LLP (refer to FIG. 4) of the pixel defining layer PDL.

The second electrode CE may be disposed on the second functional layer EFL, and the capping layer CPL may be disposed on the second electrode CE. A micro lens array MLP-R, MLP-G, and MLP-B may be disposed on the capping layer CPL. The components described with reference to FIGS. 5A and 5B may be disposed between the micro lens array MI,P-R, MLP-G, and MLP-B and the capping layer CPL.

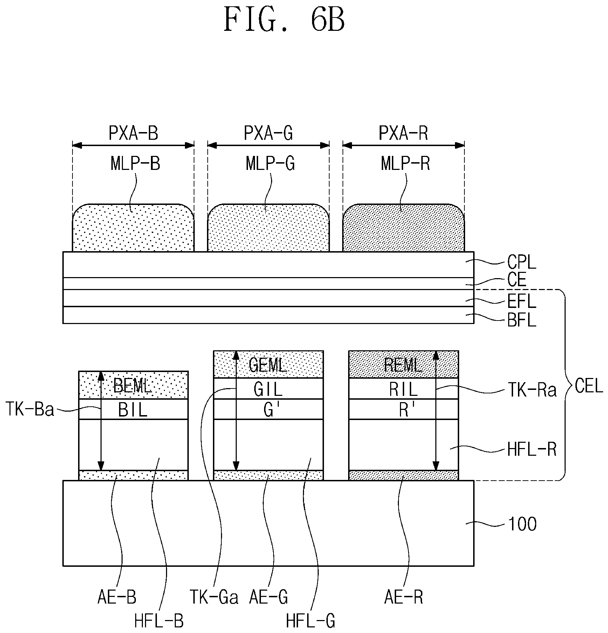

FIG. 6B is a schematic sectional view of the display panel DP (refer to FIG. 5A) according to an embodiment. In describing FIG. 6B, components identical to the components described with reference to FIG. 6A will be assigned with identical reference numerals, and descriptions thereabout will be omitted for descriptive convenience.

Referring to FIGS. 5A and 6B, the intermediate layer CEL may include first functional layers HFL-R, HFL-G, and HFL-B, the first auxiliary layers RIL and R', the second auxiliary layers GIL and G', the third auxiliary layer BIL, the first emissive layer REML, the second emissive layer GEML, the third emissive layer BEML, the buffer layer BFL, and the second functional layer EFL.

Each of the first functional layers HFL-R, HFL-G, and HFL-B may include a hole transport layer (HTL), may include a hole injection layer (HIL), or may include both the hole transport layer and the hole injection layer.

In an embodiment, the first functional layers HFL-R, HFL-G, and HFL-B may be disposed in the first to third emissive regions PXA-R, PXA-G, and PXA-B, respectively. For example, the above-described control pattern LLP (refer to FIG. 4) may be omitted. However, embodiments are not limited thereto.

In an embodiment, the first functional layer HFL-R, the first auxiliary layers RIL and R', and the first emissive layer REMI, may be formed using a first mask. The first functional layer HFL-G, the second auxiliary layers GIL and G', and the second emissive layer GEMI, may be formed using a second mask, and the first functional layer HFL-B, the third auxiliary layer BIL, and the third emissive layer BEMI, may be formed using a third mask.

Unlike those illustrated in FIGS. 6A and 6B, the intermediate layer CEL may include a common emissive layer that generates the same source light. The source light may be white light or blue light. For example, the common emissive layer may be disposed instead of the first auxiliary layers RIL and R', the second auxiliary layers GIL and G', the third auxiliary layer BIL, the first emissive layer REML, the second emissive layer GEML, and the third emissive layer BEMI, illustrated in FIGS. 6A and 6B. The common emissive layer may be connected to the first to third emissive regions PXA-R, PXA-G, and PXA-B and may be integrally disposed. However, embodiments are not limited thereto, and the common emissive layer may be subjected to patterning and formed in each of the first to third emissive regions PXA-R, PXA-G, and PXA-B.

In an embodiment, the common emissive layer may include a first sub-emissive layer, a charge generation layer, and a second sub-emissive layer sequentially stacked one above another. The first sub-emissive layer and the second sub-emissive layer may emit light of different colors. For example, the first sub-emissive layer and the second sub-emissive layer may emit light of complementary colors, respectively. For example, the first sub-emissive layer may emit blue light, and the second sub-emissive layer may emit yellow light. Accordingly, the emissive layer may provide white source light that is a combination of light provided from the first sub-emissive layer and light provided from the second sub-emissive layer. The charge generation layer may supply electrons or holes to the first sub-emissive layer and the second sub-emissive layer to improve light emission efficiency.

In an embodiment, the common emissive layer may include a first sub-emissive layer, a first charge generation layer, a second sub-emissive layer, a second charge generation layer, and a third sub-emissive layer sequentially stacked one above another. At least one of the first sub-emissive layer, the second sub-emissive layer, and the third sub-emissive layer may emit light having a color different from that of light emitted by at least another one of the first sub-emissive layer, the second sub-emissive layer, and the third sub-emissive layer. For example, the first sub-emissive layer and the third sub-emissive layer may emit first light having the same color, and the second sub-emissive layer may emit second light having a color different from that of the first light. For example, the first light and the second light may have a complementary color relationship. For example, the first sub-emissive layer and the third sub-emissive layer may emit blue light, and the second sub-emissive layer may emit yellow light. Accordingly, the common emissive layer may provide white source light that is a combination of light provided from the first sub-emissive layer, the second sub-emissive layer, and the third sub-emissive layer. The first charge generation layer may supply electrons or holes to the first sub-emissive layer and the second sub-emissive layer to improve light emission efficiency. For example, the second charge generation layer may supply electrons or holes to the second sub-emissive layer and the third sub-emissive layer to improve light emission efficiency.

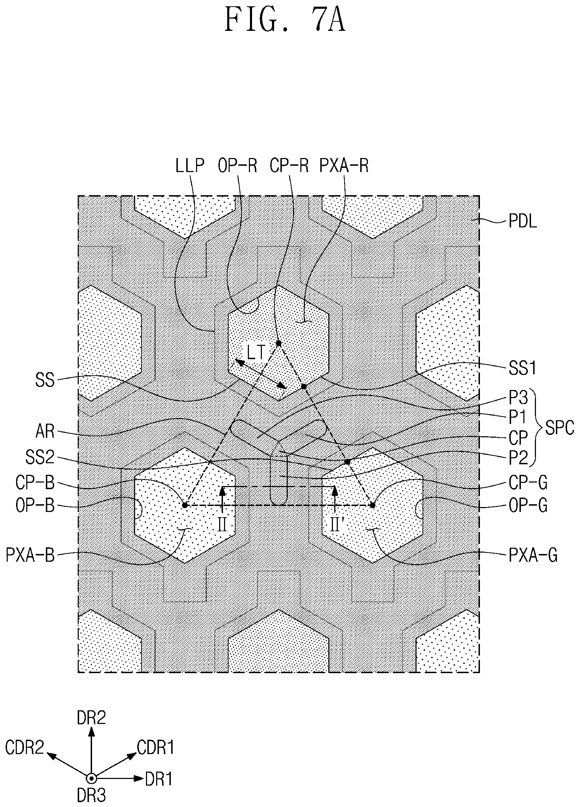

FIG. 7A is an enlarged schematic plan view illustrating a partial region of the display panel according to an embodiment.

Referring to FIG. 7A, openings OP-R, OP-G, and OP-B defined in the pixel defining layer PDL are illustrated. The openings OP-R, OP-G, and OP-B may include the first opening OP-R, the second opening OP-G, and the third opening OP-B. The first opening OP-R, the second opening OP-G, and the third opening OP-B may be adjacent to a spacer (e.g., single spacer) SPC.

In an embodiment, each of the first opening OP-R, the second opening OP-G, and the third opening OP-B may have a polygonal shape. For example, each of the first opening OP-R, the second opening OP-G, and the third opening OP-B may have a hexagonal shape when viewed from above the plane (e.g., in the third direction DR3). However, this is illustrative, and embodiments are not limited thereto.

In an embodiment, the spacer SPC may include a central portion CP, a first extension P1, a second extension P2, and a third extension P3. The central portion CP may correspond to a triangular shape (e.g., in plan view). The first extension P1 may extend from the central portion CP to be disposed between the first opening OP-R and the second opening OP-G (e.g., in plan view). The second extension P2 may extend from the central portion CP to be disposed between the second opening OP-G and the third opening OP-B (e.g., in plan view). The third extension P3 may extend from the central portion CP to be disposed between the first opening OP-R and the third opening OP-B (e.g., in plan view). Accordingly, the spacer SPC may have a tripod shape when viewed from above the plane (or in plan view).

In an embodiment, the first to third extensions P1, P2, and P3 may extend from the central portion CP in three different directions, respectively. For example, the first extension P1 may extend in a first crossing direction CDR1, the second extension P2 may extend in the direction opposite to the second direction DR2, and the third extension P3 may extend in a second crossing direction CDR2. The first crossing direction CDR1 may be a direction between the first direction DR1 and the second direction DR2, and the second crossing direction CDR2 may be a direction between the second direction DR2 and the direction opposite to the first direction DR1.

According to an embodiment, the area of the region where the spacer SPC is to be disposed may be reduced according to an increase in the resolution of the display panel DP (refer to FIG. 5A). In the case that the spacer SPC has a shape extending in at least three directions within a limited area, the rigidity of the spacer SPC may be improved. During deposition using a mask, the possibility of damage to the spacer SPC due to insufficient rigidity of the spacer SPC may be eliminated or reduced. Accordingly, the manufacturing yield and reliability of the display panel DP may be improved.

In an embodiment, end portions of the first to third extensions P1, P2, and P3 may have a round shape. The end portions of the first to third extensions P1, P2, and P3 may be disposed within a region AR defined by virtual lines connecting a first center CP-R of the first opening OP-R, a second center CP-G of the second opening OP-G, and a third center CP-B of the third opening OP-B. For example, the lengths of the first to third extensions P1, P2, and P3 may be shorter than the length LT of a side SS of each of the first to third openings OP-R, OP-G, and OP-B.

The first opening OP-R may include a first side SS1 facing the first extension P1, and the second opening OP-G may include a second side SS2 facing the first extension P1. A virtual line connecting the center of the first side SS1 and the center of the second side SS2 may be the same as a normal line extending from the center of the first side SS1. For example, the line and the normal line may be a part of the lines that define the region AR. For example, the end portion of the first extension P1 may be spaced apart from (or may not overlap) the line and the normal line, or may be aligned with the line and the normal line.

According to an embodiment, the display panel DP may be implemented to have a high resolution. For example, as the resolution is increased, the maximum width by which the first to third extensions P1, P2, and P3 are able to be disposed may be reduced, and the widths of the first to third extensions P1, P2, and P3, for example, the widths in the directions intersecting the extension directions may be decreased. Accordingly, even though the widths of the first to third extensions P1, P2, and P3 are decreased, the rigidity of the spacer SPC may be improved by limiting the extension lengths of the first to third extensions P1, P2, and P3.

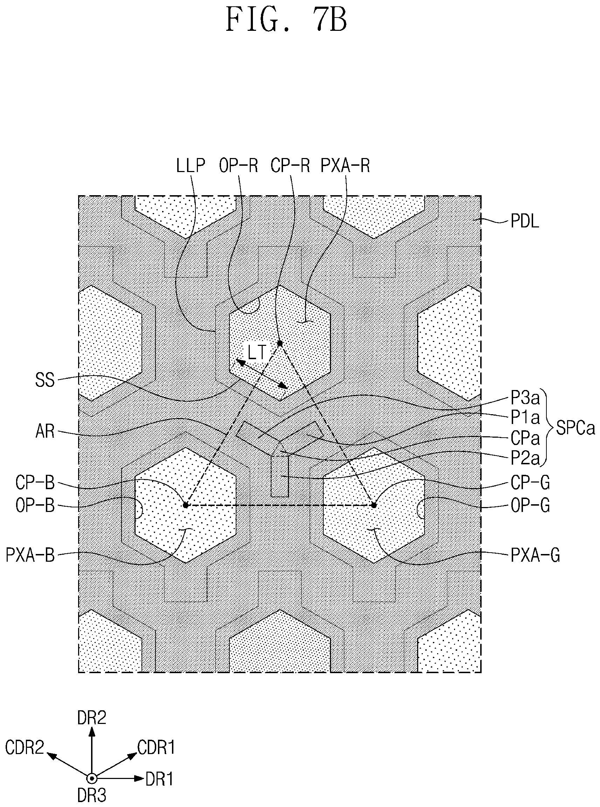

FIG. 7B is an enlarged schematic plan view illustrating a partial region of the display panel according to an embodiment. In describing FIG. 7B, components identical to the components described with reference to FIG. 7A will be assigned with identical reference numerals, and descriptions thereabout will be omitted for descriptive convenience.

Referring to FIG. 7B, a spacer SPCa may include a central portion CPa, a first extension P1a, a second extension P2a, and a third extension P3a. The first extension P1a may extend from the central portion CPa to be disposed between the first opening OP-R and the second opening OP-G (e.g., in plan view). The second extension P2a may extend from the central portion CPa to be disposed between the second opening OP-G and the third opening OP-B (e.g., in plan view). The third extension P3a may extend from the central portion CPa to be disposed between the first opening OP-R and the third opening OP-B (e.g., in plan view).

In an embodiment, end portions of the first to third extensions P1a, P2a, and P3a may have an angled shape. For example, the first to third extensions P1a, P2a, and P3a may have a quadrangular shape. The end portions of the first to third extensions P1a, P2a, and P3a may be disposed within the region AR defined by virtual lines connecting the first center CP-R of the first opening OP-R, the second center CP-G of the second opening OP-G, and the third center CP-B of the third opening OP-B. Accordingly, even though the first to third extensions P1a, P2a, and P3a are narrowed due to an increase in the resolution of the display panel DP (refer to FIG. 5A), the rigidity of the spacer SPCa may be improved by limiting the extension lengths of the first to third extensions P1a, P2a, and P3a.

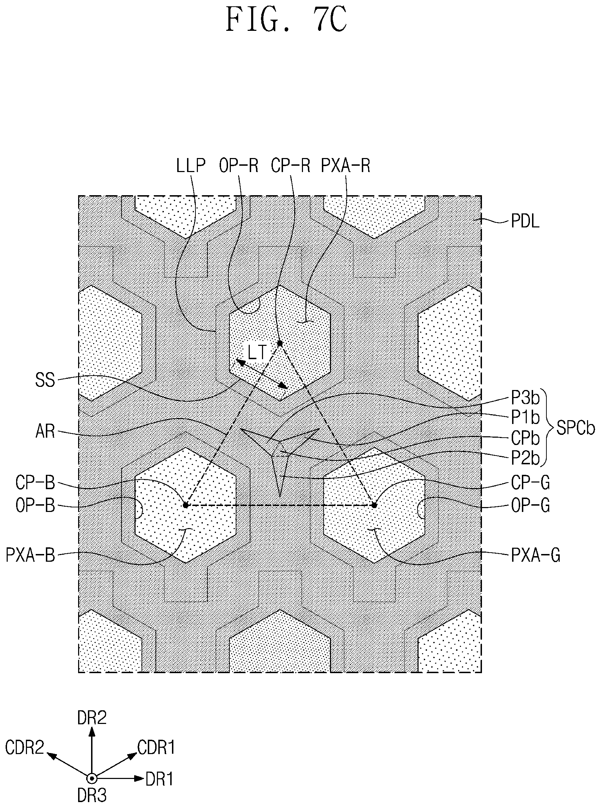

FIG. 7C is an enlarged schematic plan view illustrating a partial region of the display panel according to an embodiment. In describing FIG. 7C, components identical to the components described with reference to FIG. 7A will be assigned with identical reference numerals, and descriptions thereabout will be omitted for descriptive convenience.

Referring to FIG. 7C, a spacer SPCb may include a central portion CPb, a first extension P1b, a second extension P2b, and a third extension P3b. The first extension P1b may extend from the central portion CPb to be disposed between the first opening OP-R and the second opening OP-G (e.g., in plan view). The second extension P2b may extend from the central portion CPb to be disposed between the second opening OP-G and the third opening OP-B (e.g., in plan view). The third extension P3b may extend from the central portion CPb to be disposed between the first opening OP-R and the third opening OP-B (e.g., in plan view).

In an embodiment, end portions of the first to third extensions P1b, P2b, and P3b may have a pointed shape. For example, the central portion CPb and the first to third extensions P1b, P2b, and P3b may have a triangular shape. The end portions of the first to third extensions P1b, P2b, and P3b may be disposed within the region AR defined by virtual lines connecting the first center CP-R of the first opening OP-R, the second center CP-G of the second opening OP-G, and the third center CP-B of the third opening OP-B. Accordingly, even though the first to third extensions P1b, P2b, and P3b are narrowed due to an increase in the resolution of the display panel DP (refer to FIG. 5A), the rigidity of the spacer SPCb may be improved by limiting the extension lengths of the first to third extensions P1b, P2b, and P3b.

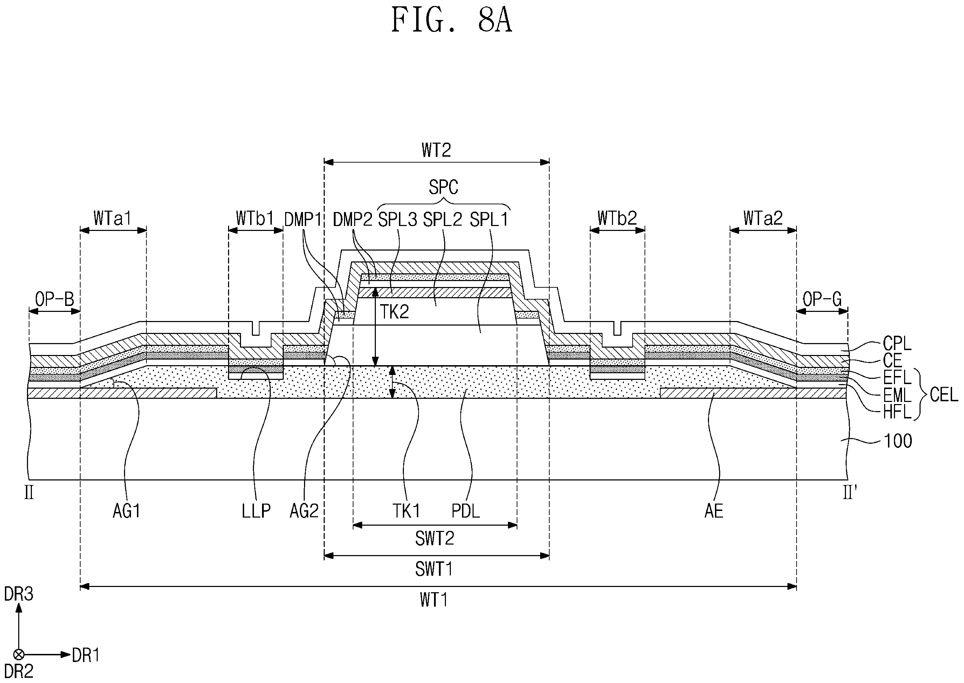

FIG. 8A is a schematic sectional view of a partial region of the display panel according to an embodiment. FIG. 8A is a schematic sectional view of the display panel taken along line II-II' of FIG. 7A. In FIG. 8A, only the circuit board 100 and the element layer 200 described with reference to FIGS. 5A to 5C are illustrated, and the encapsulation layer 300 and the optical layer 400 or 400a are omitted.

Referring to FIGS. 4, 7A, and 8A, the pixel defining layer PDL may be disposed on the circuit board 100. The openings OP for exposing portions of the first electrodes AE may be defined in the pixel defining layer PDL. The openings OP may include the first opening OP-R, the second opening OP-G, and the third opening OP-B. The region between the second opening OP-G and the third opening OP-B is illustrated in FIG. 8A.

The control patterns LLP recessed from the upper surface of the pixel defining layer PDL may be defined in the pixel defining layer PDL. The control patterns LLP may be referred to as valleys. The control patterns LLP may surround at least portions of the first to third openings OP-R, OP-G, and OP-B, respectively. The spacer SPC may be disposed between the control patterns LLP.

The spacer SPC may be disposed on the pixel defining layer PDL. In an embodiment, the spacer SPC and the pixel defining layer PDL may include an inorganic material. For example, the spacer SPC and the pixel defining layer PDL may include at least one of silicon oxide, silicon nitride, and silicon oxy nitride.

In an embodiment, a first angle AG1 of a side surface of the pixel defining layer PDL with respect to a bottom surface of the pixel defining layer PDL may be about 40 degrees or less. For example, the intermediate layer CEL disposed on the pixel defining layer PDL may be stably formed. However, the first angle AG1 is only an example and is not limited thereto. In an embodiment, a second angle AG2 of a side surface of the spacer SPC with respect to a bottom surface of the spacer SPC may be greater than or equal to the first angle AG1 of the side surface of the pixel defining layer PDL with respect to the bottom surface of the pixel defining layer PDL. Even though a portion of the intermediate layer CEL or the second electrode CE is disconnected by the spacer SPC, an influence on the driving of the display panel DP (refer to FIG. 5A) may be limited because the arrangement density of the spacer SPC may be less than or equal to half of the density of the pixel density, for example, about 1/8 of the density of the pixel density. Accordingly, the second angle AG2 of the spacer SPC may be designed in various ways without being limited to a specific angle or less.

In an embodiment, the spacer SPC may include a plurality of layers. For example, the spacer SPC may include a first layer SPL1, a second layer SPL2 disposed on the first layer SPL1, and a third layer SPL3 disposed on the second layer SPL2. The first width SWT1 of the first layer SPL1 may be greater than the second width SWT2 of the second layer SPL2. In the case that the spacer SPC has a stepped structure, a monomer may smoothly flow in the case that the organic encapsulation layer 320 (refer to FIG. 5A) is formed. Accordingly, the organic encapsulation layer 320 may be more readily flattened. However, the shape of the spacer SPC is not limited thereto. For example, the first width SWT1 and the second width SWT2 may be substantially the same as each other. The third layer SPL3 may be thinner than the first layer SPL1 and the second layer SPL2.

In an embodiment, each of the first layer SPL1 and the second layer SPL2 may include at least one of silicon oxide, silicon nitride, and silicon oxy nitride. The third layer SPL3 may be used as a mask (e.g., a hard mask) in the case that the first and second layers SPL1 and SPL2 are subjected to patterning. For example, the third layer SPL3 may include metal, metal alloy, metal oxide, metal nitride, or transparent conductive oxide. For example, the third layer SPL3 may include titanium (Ti), titanium nitride (TiNₓ), nickel (Ni), gold (Au), molybdenum (Mo), indium tin oxide (ITO), or indium zinc oxide (IZO).

The intermediate layer CEL, the second electrode CE, and the capping layer CPL may be sequentially disposed on the first electrode AE, the pixel defining layer PDL, and the spacer SPC. The intermediate layer CEL may be disposed in the control patterns LLP defined in the upper surface of the pixel defining layer PDL. In an embodiment, the resistance of the intermediate layer CEL (e.g., the first functional layer HFL) may be increased by the control patterns LLP. For example, the first functional layer HFL may be disconnected (or separated) by the control patterns LLP. Accordingly, an occurrence of lateral leakage current, color mixing between adjacent pixel regions, and deterioration in luminance may be prevented.

First dummy layers DMP1 may be disposed on the first layer SPL1, and second dummy layers DMP2 may be disposed on the third layer SPL3. Each of the first dummy layers DMP1 and the second dummy layers DMP2 may include the same layers as the first functional layer HFL and the second functional layer EFL. In an embodiment, each of the first dummy layers DMP1 and the second dummy layers DMP2 may further include a layer including the same material as an emissive layer EML. In another example, a process of removing the first dummy layers DMP1 and the second dummy layers DMP2 may be added, and the first dummy layers DMP1 and the second dummy layers DMP2 may be omitted.

In an embodiment, at least one of the first to third layers SPL1, SPL2, and SPL3 may include a conductive material. For example, the second electrode CE may be brought into contact with the at least one layer of the spacer SPC that includes the conductive material. Accordingly, even though the second electrode CE is disconnected by the spacer SPC, the disconnected portion may be connected by the spacer SPC. In another example, even though the resistance of the second electrode CE is increased by the spacer SPC, the increased resistance may be lowered as the spacer SPC and the second electrode CE are brought into contact with each other.

In an embodiment, the first thickness TK1 of the pixel defining layer PDL may range from about 300Å to about 1000Å, but embodiments are not limited thereto. The second thickness TK2 of the spacer SPC may be greater than or equal to the first thickness TK1 of the pixel defining layer PDL, but embodiments are not limited thereto.

In an embodiment, the second thickness TK2 of the spacer SPC may be greater than or equal to the maximum organic material deposition thickness that is likely to occur during deposition using a mask. For example, referring to FIG. 6A, the first thickness TK-R of the first auxiliary layers RIL and R' and the first emissive layer REML, the second thickness TK-G of the second auxiliary layers GIL and G' and the second emissive layer GEML, and the third thickness TK-B of the third auxiliary layer BIL and the third emissive layer BEMI, are illustrated. For example, referring to FIG. 6B, the first thickness TK-Ra of the first functional layer HFL-R, the first auxiliary layers RIL and R', and the first emissive layer REML, the second thickness TK-Ga of the first functional layer HFL-G, the second auxiliary layers GIL and G', and the second emissive layer GEML, and the third thickness TK-Ba of the first functional layer HFL-B, the third auxiliary layer BIL, and the third emissive layer BEMI, are illustrated.

In an embodiment, the second thickness TK2 of the spacer SPC may be defined to be greater than or equal to the sum of the two greatest thicknesses among the first to third thicknesses TK-R, TK-G, and TK-B. In another example, the second thickness TK2 of the spacer SPC may be defined to be greater than or equal to the sum of the two greatest thicknesses among the first to third thicknesses TK-Ra, TK-Ga, and TK-Ba. For example, the first thickness TK-R, the second thickness TK-G, and the third thickness TK-B may be about 0.25 µm, about 0.2 µm, and about 0.15 µm, respectively. For example, the second thickness TK2 of the spacer SPC may be about 0.45 µm or more. However, these are only thicknesses determined in consideration of an alignment error of a mask, and embodiments are not limited thereto.

In an embodiment, the second thickness TK2 of the spacer SPC may be defined to be greater than or equal to the greatest thickness among the first to third thicknesses TK-R, TK-G, and TK-B. In another example, the second thickness TK2 of the spacer SPC may be defined to be greater than or equal to the greatest thickness among the first to third thicknesses TK-Ra, TK-Ga, and TK-Ba. For example, the second thickness TK2 of the spacer SPC may be about 0.25 µm or more or about 0.3 µm or more.

In an embodiment, the pixel defining layer PDL may have a first width WT1. The first width WT1 may correspond to the distance between the openings OP-G and OP-B adjacent to each other among the openings OP-R, OP-G, and OP-B. As the resolution of the display panel DP is increased, the first width WT1 may be decreased. For example, the first width WT1 may be several µm. For example, the first width WT1 may range from about 2 µm to tens of µm. For example, the first width WT1 may be about 2 µm.

The width WT2 of the region where the spacer SPC is formed may correspond to a numeral value obtained by subtracting the widths WTa1 and WTa2 of tapered regions, the widths WTb1 and WTb2 of the regions where the control patterns LLP are formed, and the width of a process margin from the first width WT1 of the pixel defining layer PDL. The width WT2 may be defined as the second width WT2 of the spacer SPC. For example, in the case that the first width WT1 of the pixel defining layer PDL is about 2 µm or more, the second width WT2 of the spacer SPC may be about 0.6 µm or more. However, the numerical values are illustrative, and embodiments are not limited thereto. For example, the process margin may vary according to exposure equipment, and the widths WTa1 and WTa2 of the tapered regions may be changed according to the material of the pixel defining layer PDL. Accordingly, the second width WT2 of the spacer SPC is not limited to a specific numerical value.

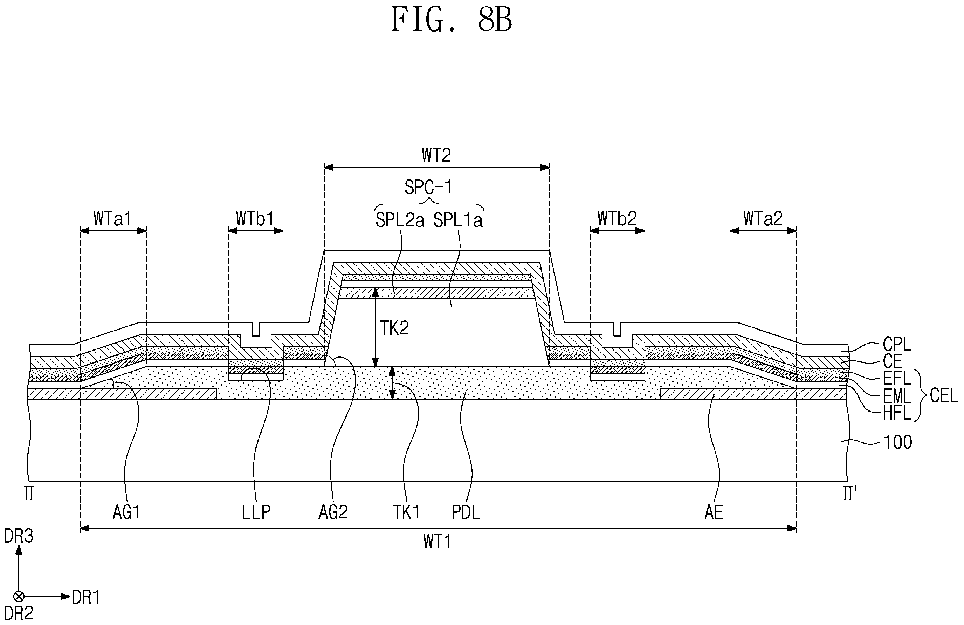

FIG. 8B is a schematic sectional view of a partial region of the display panel according to an embodiment. In describing FIG. 8B, components identical to the components described with reference to FIG. 8A will be assigned with identical reference numerals, and descriptions thereabout will be omitted for descriptive convenience.

Referring to FIGS. 7A and 8B, a spacer SPC-1 may be disposed on the pixel defining layer PDL.

In an embodiment, the spacer SPC-1 may include a plurality of layers. For example, the spacer SPC-1 may include a first layer SPL1a and a second layer SPL2a disposed on the first layer SPL1a. The second layer SPL2a may be thinner than the first layer SPL1a. The second layer SPL2a may be used as a mask (e.g., a hard mask) in the case that the first layer SPL1a is subjected to patterning.

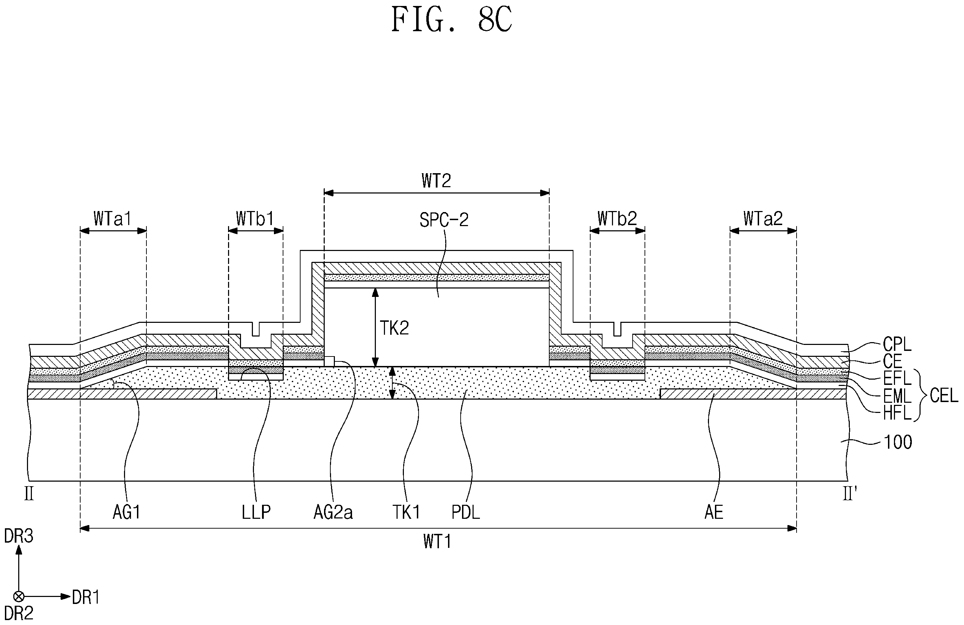

FIG. 8C is a schematic sectional view of a partial region of the display panel according to an embodiment. In describing FIG. 8C, components identical to the components described with reference to FIG. 8A will be assigned with identical reference numerals, and descriptions thereabout will be omitted for descriptive convenience.

Referring to FIGS. 7A and 8C, a spacer SPC-2 may be disposed on the pixel defining layer PDL. The spacer SPC-2 may have a single-layer structure or a multi-layer structure. The spacer SPC-2 may include an inorganic material.

In an embodiment, a second angle AG2a of a side surface of the spacer SPC-2 with respect to a bottom surface of the spacer SPC-2 may be greater than or equal to a first angle AG1 of the side surface of the pixel defining layer PDL with respect to the bottom surface of the pixel defining layer PDL. The first angle AG1 may be about 40 degrees or less, and the second angle AG2a may be about 90 degrees. However, the numerical values of the first angle AG1 and the second angle AG2a are illustrative, and embodiments are not limited thereto.

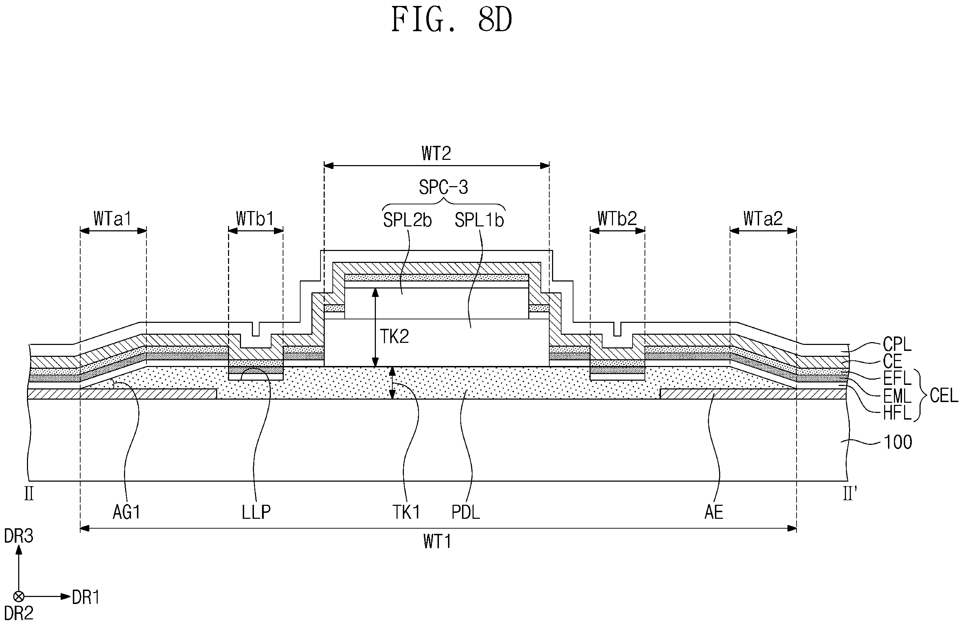

FIG. 8D is a schematic sectional view of a partial region of the display panel according to an embodiment. In describing FIG. 8D, components identical to the components described with reference to FIG. 8A will be assigned with identical reference numerals, and descriptions thereabout will be omitted for descriptive convenience.

Referring to FIGS. 7A and 8D, a spacer SPC-3 may be disposed on the pixel defining layer PDL. The spacer SPC-3 may include a first layer SPL1b and a second layer SPL2b. Each of the first layer SPL1b and the second layer SPL2b may have a single-layer structure or a multi-layer structure. Each of the first layer SPL1b and the second layer SPL2b may include an inorganic material.

The first width of the first layer SPL1b may be greater than the second width of the second layer SPL2b. However, embodiments are not limited thereto

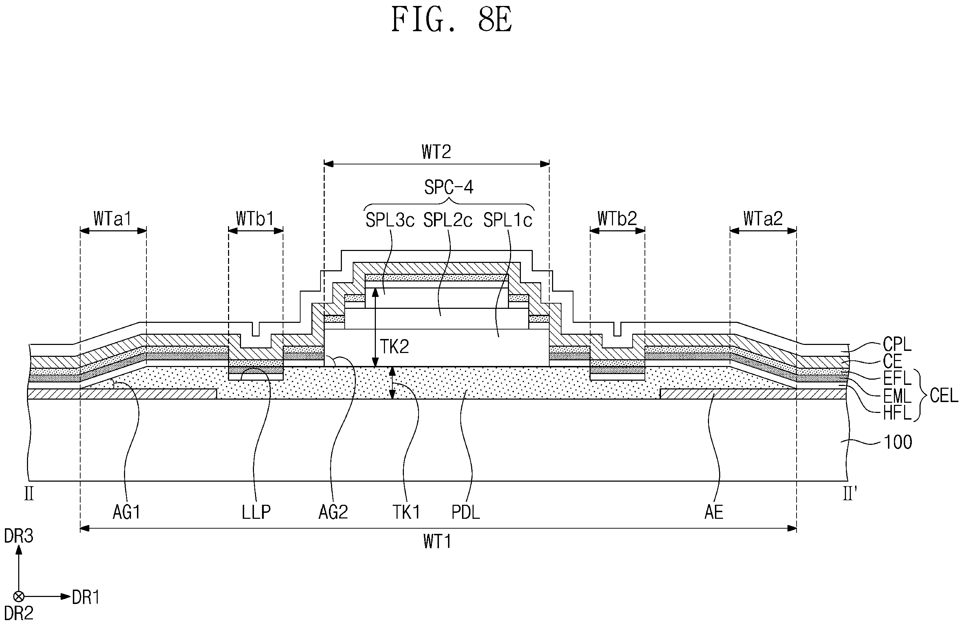

FIG. 8E is a schematic sectional view of a partial region of the display panel according to an embodiment. In describing FIG. 8E, components identical to the components described with reference to FIG. 8A will be assigned with identical reference numerals, and descriptions thereabout will be omitted for descriptive convenience.

Referring to FIGS. 7A and 8E, a spacer SPC-4 may be disposed on the pixel defining layer PDL. The spacer SPC-4 may include a first layer SPL1c, a second layer SPL2c, and a third layer SPL3c. Each of the first layer SPL1c, the second layer SPL2c, and the third layer SPL3c may have a single-layer structure or a multi-layer structure. Each of the first layer SPL1c, the second layer SPL2c, and the third layer SPL3c may include an inorganic material.

The first width of the first layer SPL1c may be greater than the second width of the second layer SPL2c, and the second width of the second layer SPL2c may be greater than the third width of the third layer SPL3c. However, embodiments are not limited thereto.

The sectional structures of the spacers SPC, and SPC-1 to SPC-4 described with reference to FIGS. 8A to 8E may be applied to the planar structures of the spacers SPC, SPCa and SPCb described with reference to FIGS. 7A to 7C.

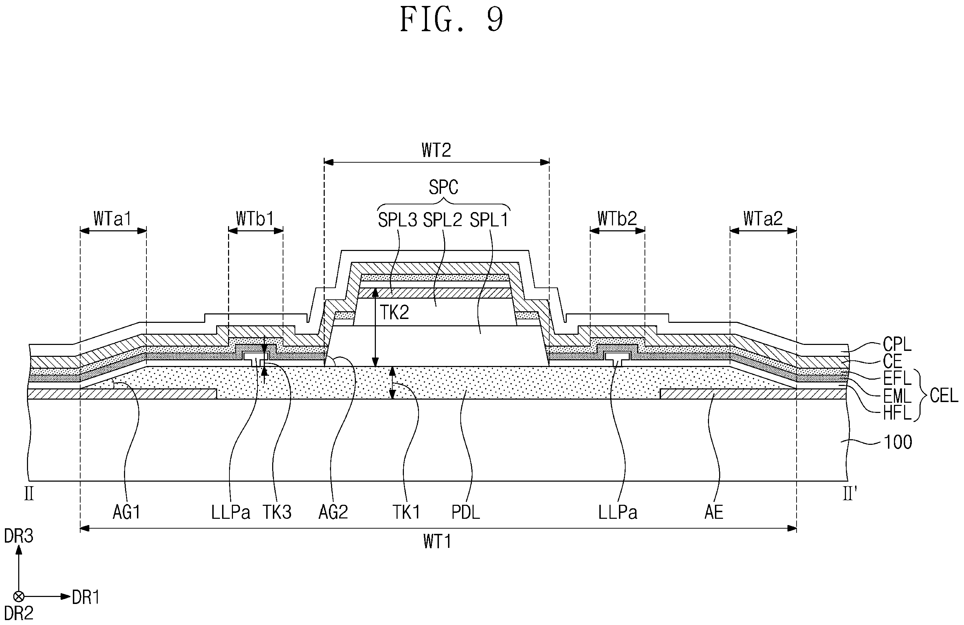

FIG. 9 is a schematic sectional view of a partial region of the display panel according to an embodiment. In describing FIG. 9, components identical to the components described with reference to FIG. 8A will be assigned with identical reference numerals, and descriptions thereabout will be omitted for descriptive convenience.

Referring to FIGS. 4, 7A, and 9, the control patterns LLPa may be disposed on the pixel defining layer PDL. The control patterns LLPa may be referred to as protruding patterns. The second thickness TK2 of the spacer SPC may be greater than or equal to the third thickness TK3 of each of the control patterns LLPa. The spacer SPC may be disposed between the control patterns LLPa.

The intermediate layer CEL may be disposed on the first electrode AE, the pixel defining layer PDL, and the control pattern LLPa. In an embodiment, the thickness of the intermediate layer CEL, e.g., the first functional layer HFL may be decreased by the control patterns LLPa. In another example, the first functional layer HFL may be disconnected by the control patterns LLPa. For example, leakage of current to the portion where the control pattern LLPa is formed may be prevented.

According to the above description, the area of the region where the spacer is to be disposed may be reduced with an increase in the resolution of the display panel. The spacer may have a shape extending in at least three directions. Accordingly, the rigidity of the spacer may be improved. Furthermore, even though the widths of the extensions of the spacer are decreased due to the limited area, the rigidity of the spacer may be improved by limiting the extension lengths of the extensions. Accordingly, during deposition using a mask, the possibility of damage to the spacer due to insufficient rigidity may be eliminated or reduced. Thus, the manufacturing yield and reliability of the display panel may be improved.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A display panel comprising:
a circuit board including a pixel circuit; and
an element layer disposed on the circuit board, the element layer including:
a plurality of light emitting elements,
a pixel defining layer having a plurality of openings overlapping the plurality of light emitting elements, respectively, and
a spacer disposed on the pixel defining layer, wherein
the plurality of openings include a first opening, a second opening, and a third opening, each of the first, second, and third openings adjacent to the spacer,
the spacer includes:
a central portion disposed between the first, second, and third openings,
a first extension extending from the central portion to be disposed between the first opening and the second opening,
a second extension extending from the central portion to be disposed between the second opening and the third opening, and
a third extension extending from the central portion to be disposed between the third opening and the first opening, and
end portions of the first, second, and third extensions are disposed in a region defined by virtual lines connecting a first center of the first opening, a second center of the second opening, and a third center of the third opening.

2. The display panel of claim 1, wherein
the spacer includes a plurality of layers, and
at least one layer among the plurality of layers includes a conductive material.

3. The display panel of claim 1 or claim 2, wherein the spacer includes:
a first layer having a first width, and
a second layer disposed on the first layer and having a second width smaller than the first width of the first layer.

4. The display panel of any one of claims 1 to 3, wherein
the spacer includes a plurality of spacers,
the plurality of spacers include a first spacer and a second spacer closest to the first spacer, and
at least two light emitting elements among the plurality of light emitting elements are disposed between the first spacer and the second spacer.

5. The display panel of any one of claims 1 to 4, wherein each of the first opening, the second opening, and the third opening has a polygonal shape.

6. The display panel of claim 5, wherein
the first opening includes a first side facing the first extension,
the second opening includes a second side facing the first extension, and
the end portion of the first extension is aligned with or spaced apart from a virtual line connecting a center of the first side and a center of the second side.

7. The display panel of any one of claims 1 to 6, wherein
the pixel defining layer includes an inorganic material, and
the spacer includes an inorganic material.

8. The display panel of any one of claims 1 to 7, wherein the end portions of the first, second, and third extensions have a round shape, an angled shape, or a pointed shape.

9. The display panel of any one of claims 1 to 8, wherein a first angle of a side surface of the pixel defining layer defining the first opening with respect to a bottom surface of the pixel defining layer is about 40 degrees or less.

10. The display panel of claim 9, wherein a second angle of a side surface of the spacer with respect to a bottom surface of the spacer is greater than or equal to the first angle.

11. The display panel of any one of claims 1 to 10, wherein the spacer is thicker than the pixel defining layer.

12. The display panel of any one of claims 1 to 11, wherein
a plurality of valleys recessed from an upper surface of the pixel defining layer are disposed in the pixel defining layer, and
the plurality of valleys surround at least portions of the first, second, and third openings, respectively.

13. The display panel of claim 12, wherein the spacer is disposed between the plurality of valleys.

14. The display panel of any one of claims 1 to 11, further comprising:
a plurality of protruding patterns disposed on the pixel defining layer, wherein the plurality of protruding patterns surround at least portions of the first, second, and third openings, respectively.

15. The display panel of claim 14, wherein the spacer has a thickness greater than thicknesses of the plurality of protruding patterns.
